# EUROPEAN PATENT SPECIFICATION

(11) **EP 3 561 389 B1**
(45) Date of publication and mention of the grant of the patent: **27.01.2021**
(21) Application number: 18169886.1
(22) Date of filing: 27.04.2018
(51) Int. Cl.: F24C 7/08, H01H 47/00, H03K 17/95, H05B 1/02

(54) **DOMESTIC APPLIANCE ADAPTED FOR STAND-BY MODE**
FÜR BEREITSCHAFTSBETRIEB ANGEPASSTES HAUSHALTSGERÄT
APPAREIL MÉNAGER CONÇU POUR UN MODE VEILLE

(43) Date of publication of application: 30.10.2019
(73) Proprietor: ELECTROLUX APPLIANCES AKTIEBOLAG, 105 45 Stockholm (SE)
(72) Inventor: VIROLI, Alex, 47122 Forli (IT); MARTINI, Filippo, 47100 Forli (IT); CHRISTIANSEN, Svend Erik, 47100 Forli (IT); SCOTTO D'APOLLONIA, Adriano, 47122 Forli (IT); JEANNETEAU, Laurent, 47122 Forli (IT); BALEST, Frederico, 47122 Forli (IT)
(74) Representative: Electrolux Group Patents

(56) References cited:
- WO-A2-2015/128578
- DE-A1-102006 007 169
- DE-A1-102013 226 386
- US-A- 5 920 131
- US-B1- 6 198 079

## Description

The present invention relates to a domestic appliance adapted to be switched into a stand-by mode. In particular, the present invention relates to a cooking hob adapted for stand-by mode. Preferably, the present invention relates to an induction cooking hob adapted for stand-by mode.

A domestic appliance adapted for stand-by mode allows that said domestic appliance is activatable and deactivatable in a simple way. In particular, such a domestic appliance is activatable and deactivatable by a remote control. However, the domestic appliance consumes energy during the stand-by mode. This unneeded energy consumption impairs the economy of the domestic appliance.

US 5,920,131 A discloses an arrangement for the control of electrically controllable appliances, particularly electric cooking hobs, comprising operating elements, which are magnetically held in contactless manner on the top of a plate, e. g. a glass ceramics plate. A magnet below the plate magnetically secures the operating element, which can be rotated in contactless manner. A latching relay is provided for enabling the appliance to be supplied with power by the mains voltage. If all operating elements are in off-condition, the latching relay opens and the appliance is disconnected from the mains voltage.

DE 10 2013 226 386 A1 discloses a domestic appliance comprising a circuit including a first circuit part and a second circuit part, which is galvanically isolated from the first circuit part. The second circuit part accommodates a third circuit part and the second circuit part comprises a first control device adapted to interrupt a supply of the third circuit part. The third circuit part controls the first circuit part, while the first circuit part is configured to provide supply of the third circuit part for a predetermined holding period.

US 6,198,079 B1 discloses a control for an electrical appliance having at least one electrical functional device contained in the appliance, the control containing at least one power switching device.

It is an object of the present invention to provide a domestic appliance adapted to be switched into a stand-by mode with low complexity, wherein said domestic appliance does not consume any energy during the stand-by mode.

The object is achieved by the domestic appliance adapted to be switched into a stand-by mode according to claim 1.

Preferred embodiments may be taken from the dependent claims, and, beyond that, from the following description, in particular comprising various embodiments as covered and described in the annexed claims.

A domestic appliance adapted to be switched into a stand-by mode is provided, wherein:
- the domestic appliance comprises at least one switch being switchable between an open state and a closed state, wherein the switch is in the open state in the stand-by mode,
- the switch includes at least one high-voltage input and at least one high-voltage output,
- the high-voltage input and the high-voltage output are adapted to carry mains voltage,
- the high-voltage input and the high-voltage output are galvanically disconnected from each other in the open state of the switch,
- the high-voltage input and the high-voltage output are galvanically connected to each other in the closed state of the switch, and
- the switch is controllable by at least one control device electrically isolated from the domestic appliance.

According to the present invention a control input of the switch is connected to a receiving coil being responsive to a magnetic field generated by the control device, the domestic appliance is an induction cooking hob comprising and induction coil, wherein the receiving coil is the induction coil, and a rectifier is preferably interconnected between the receiving coil and the control input of the switch.

The core of the present invention is the galvanic separation between the domestic appliance with the switch on the one hand and the control device on the other hand, wherein the control device switches and controls the switch. The electrical isolation between the switch and the control device prevents current flow during the stand-by mode, so that the domestic appliance does not consume any electric energy during the stand-by mode. Further, the fact that the induction coil, which is already present in the induction cooking hob, is used as a receiving coil for a control input, contributes to low complexity of the domestic appliance.

In particular, the high-voltage input of the switch is connectable or connected to a mains line.

Preferably, the high-voltage output of the switch is connected to at least one power electronics and/or power supply.

For example, the control device is an integrated part of the domestic appliance and/or an external part corresponding with the domestic appliance.

Preferably, the power electronics is adapted for driving, i.e. for supplying power to, at least one high-voltage appliance.

In particular, the power supply is adapted for generating at one low voltage, wherein preferably said low voltage is provided for at least one control unit.

In particular, the switch is a relay. The relay allows a reliable galvanic disconnection.

Further, the control device may be a compact separate device, wherein said separate device is an integrated part of the domestic appliance or an external device. In the latter case, the control device is removable from the domestic appliance.

Preferably, the control device comprises at least one further coil.

Additionally, the control device may comprise at least one transmitting device, wherein preferably said transmitting device is provided for driving the further coil.

Moreover, the control device may include at least one active NFC or RFID circuit.

At last, the control device may include at least one capacitor, wherein said capacitor is loadable during a standard operation of the domestic appliance.

In particular, the energy stored in said capacitor is adapted for supplying an auxiliary power supply, wherein said auxiliary power supply is provided for closing the switch in order to start up the domestic appliance.

Novel and inventive features of the present invention are set forth in the appended claims.

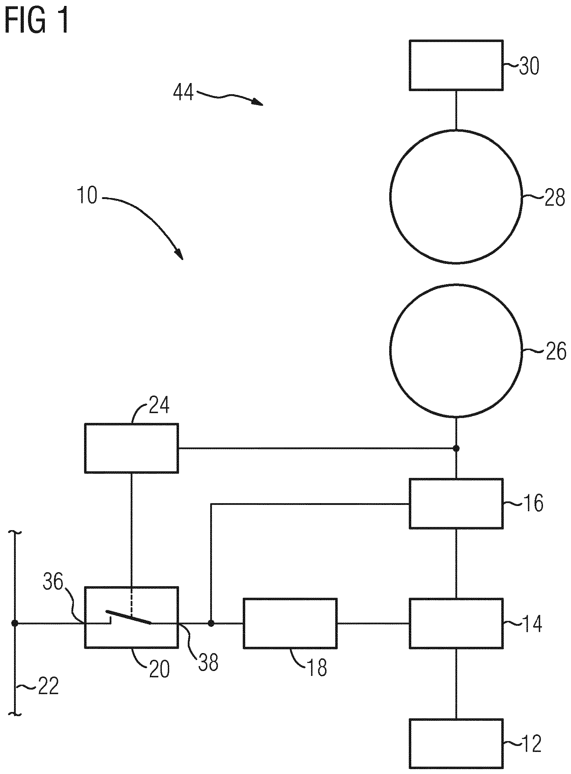

The present invention will be described in further detail with reference to the drawings, in which
- FIG 1: illustrates a schematic circuit diagram of a domestic appliance according to a preferred embodiment of the present invention.

FIG 1 illustrates a schematic circuit diagram of a domestic appliance 10 according to a preferred embodiment of the present invention. In this example, the domestic appliance 10 is an induction cooking hob. In general, the domestic appliance 10 is a device, which includes at least one coil 26.

The domestic appliance 10 comprises a user interface 12, a control unit 14, a power electronics 16, a power supply 18, a switch 20, an auxiliary power supply 24 and a first coil 26. For example, the switch 20 is a relay. In this embodiment, the first coil 26 is an induction coil. Further, a separate device 44 comprises a second coil 28 and a transmitting device 30. Said separate device 44 may be an integrated part of the domestic appliance 10 or an external device.

For example, the separate device 44 may be a blender, a kettle or a toaster. Such small separate devices 44 may use the second coil 28 for two purposes. On the one hand, the second coil 28 is used for transferring energy to the first coil 26 in the beginning, which energy is necessary for starting up the domestic appliance 10. For example, the energy is stored in a battery. On the other hand, the second coil 28 is used for receiving power from the first coil 26 in order to supply the separate device 44.

Further, the separate device 44 may only be used for starting up the domestic appliance 10, wherein afterwards said separate device 44 is removed from the proximity of the first coil 26.

Moreover, the transmitting device 30 of the separate device 44 may be implemented as an oscillator for applying an alternating current to the second coil 28. For example, said alternating current may have a frequency between 20 kHz and 50 kHz.

The user interface 12 is connected to a control input of the control unit 14. A control output of the control unit 14 is connected to a control input of the power electronics 16. Further, a low-voltage input of the control unit 14 is connected to a low-voltage output of the power supply 18. A high-voltage input of the switch 20 is connected to a mains line 22. A high-voltage output of the switch 20 is connected to a high-voltage input of the power electronics 16 and to a high-voltage input of the power supply 18. An output of the power electronics 16 is connected to the first coil 26 and to an input of the auxiliary power supply 24. A low-voltage output of the auxiliary power supply 24 is connected to a control input of the switch 20.

The switch 20 connects the domestic appliance 10 to the mains line 22. The switch 20 is open, when the domestic appliance 10 is in a stand-by mode, so that the domestic appliance 10 is electrically isolated from the mains line 22. When the switch 20 is closed, then the high-voltage input of the power electronics 16 and the high-voltage input of power supply 18 are connected to the mains line 22. The power electronics 16 drives the first coil 26, while the power supply 18 generates at least one low voltage, e.g. 5 V and/or 12 V, for the control unit 14. In general, an arbitrary low voltage value is suitable for the control unit 14. The control unit 14 includes one or more microcontrollers, receives signals from the user interface 12 and drives the power electronics 16 according to said signals from the user interface 12.

When the second coil 28 of the separate device 44 is arranged in the proximity of the first coil 26 and additionally said second coil 28 is driven by the transmitting device 30, then power can be transferred from the separate device 44 to the proper domestic appliance 10. When the transmitting device 30 drives the second coil 28, then a magnetic field is generated by the second coil 28. In turn, said magnetic field induces alternating current in the first coil 26. Then, the induced alternating current is rectified by the auxiliary power supply 24 in order to obtain an appropriate voltage for closing the switch 20. When the switch 22 is closed, then the power supply 18 is activated and generates the low voltage for the control unit 14, while the power electronics 16 is provided with high voltage from the mains line 22. In turn, the power electronics 16 provides the auxiliary power supply 24 with alternating current. Said alternating current is rectified by the auxiliary power supply 24 in order to keep the switch 20 closed. Alternatively, the low-voltage output of the power supply 18 is directly connected to the control input of the switch 20 in order to keep the switch 20 closed.

The auxiliary power supply 24 is provided for closing the switch 20 in order to start up the domestic appliance 10. After the start-up the second coil 28 can be removed from the domestic appliance 10 and the auxiliary power supply 24 stops working.

When a user switches off the domestic appliance 10 by the user interface 12, then the switch 20 is opened by the control unit 14, wherein the domestic appliance 10 does not consume any power.

According to a last embodiment of the present invention a large capacitor is used, wherein said capacitor is loaded during the normal operation of the domestic appliance 10. The energy stored in the capacitor may supply the auxiliary power supply 24.

The embodiment in the figure may relate to a preferred embodiment, while all elements and features described in connection with said embodiment may be used, as far as appropriate, in combination with any other embodiment and feature as discussed herein, in particular related to any other embodiment discussed further above.

The features of the present invention disclosed in the specification, the claims, examples and/or the figures may both separately and in any combination thereof be material for realizing the invention in various forms thereof.

### List of reference numerals

- 10: domestic appliance
- 12: user interface
- 14: control unit
- 16: power electronics
- 18: power supply
- 20: switch
- 22: mains line
- 24: auxiliary power supply
- 26: first coil
- 28: second coil
- 30: transmitting device
- 34: cooking panel, dielectric panel
- 36: high-voltage input
- 38: high-voltage output
- 44: control device, separate device

## Claims

1. A domestic appliance (10) adapted to be switched into a stand-by mode, wherein:
- the domestic appliance (10) comprises at least one switch (20) being switchable between an open state and a closed state, wherein the switch (20) is in the open state in the stand-by mode,
- the switch (20) includes at least one high-voltage input and at least one high-voltage output,
- the high-voltage input and the high-voltage output are adapted to carry mains voltage,
- the high-voltage input and the high-voltage output are galvanically disconnected from each other in the open state of the switch (20),
- the high-voltage input and the high-voltage output are galvanically connected to each other in the closed state of the switch (20), and
- the switch (20) is controllable by at least one control device (44) electrically isolated from the domestic appliance (10),
**characterised in that**
- a control input of the switch (20) is connected to a receiving coil (26) being responsive to a magnetic field generated by the control device (44),
- the domestic appliance (10) is an induction cooking hob comprising an induction coil, wherein the receiving coil (26) is the induction coil, and
- a rectifier is preferably interconnected between the receiving coil (26) and the control input of the switch (20).

2. The domestic appliance according to claim 1, **characterised in that**
the high-voltage input (36) of the switch (20) is connectable or connected to a mains line (22).

3. The domestic appliance according to claim 1 or 2, **characterised in that**
the high-voltage output (38) of the switch (20) is connected to at least one power electronics (16) and/or power supply (18).

4. The domestic appliance according to any one of the preceding claims,
**characterised in that**
the control device (44) is an integrated part of the domestic appliance (10) and/or an external part corresponding with the domestic appliance (10).

5. The domestic appliance according to claim 3,
**characterised in that**
the power electronics (16) is adapted for supplying power to at least one high-voltage appliance (26).

6. The domestic appliance according to claim 3,
**characterised in that**
the power supply (18) is adapted for generating at one low voltage, wherein preferably said low voltage is provided for at least one control unit (14).

7. The domestic appliance according to any one of the preceding claims,
**characterised in that**
the switch is a relay (20).

8. The domestic appliance according to any one of the preceding claims,
**characterised in that**
the control device (44) is a compact separate device (28, 30), wherein said separate device (28, 30) is an integrated part of the domestic appliance (10) or an external device.

9. The domestic appliance according to any one of the preceding claims,
**characterised in that**
the control device (44) comprises at least one further coil (28).

10. The domestic appliance according to claim 9,
**characterised in that**
the control device (44) comprises at least one transmitting device (30), wherein preferably said transmitting device (30) is provided for driving the further coil (28).

11. The domestic appliance according to any one of the preceding claims,
**characterised in that**
the control device (44) includes at least one active NFC or RFID circuit.

12. The domestic appliance according to any one of the preceding claims,
**characterised in that**
the control device (28, 30) includes at least one capacitor, wherein said capacitor is loadable during a standard operation of the domestic appliance (10).

13. The domestic appliance according to claim 12,
**characterised in that**
the energy stored in said capacitor is adapted for supplying an auxiliary power supply (24), wherein said auxiliary power supply (24) is provided for closing the switch (20) in order to start up the domestic appliance (10).

## Patentansprüche

1. Haushaltsgerät (10), das in einen Bereitschaftsbetrieb geschaltet werden kann, wobei:
- das Haushaltsgerät (10) wenigstens einen Schalter (20) enthält, der zwischen einem geöffneten Zustand und einem geschlossenen Zustand geschaltet werden kann, wobei der Schalter (20) in dem Bereitschaftsbetrieb in dem geöffneten Zustand ist,
- der Schalter (20) wenigstens einen Hochspannungseingang und wenigstens einen Hochspannungsausgang besitzt,
- der Hochspannungseingang und der Hochspannungsausgang dafür ausgelegt sind, Netzspannung zu führen,
- der Hochspannungseingang und der Hochspannungsausgang im geöffneten Zustand des Schalters (20) galvanisch voneinander getrennt sind,
- der Hochspannungseingang und der Hochspannungsausgang im geschlossenen Zustand des Schalters (20) galvanisch miteinander verbunden sind und
- der Schalter (20) durch wenigstens eine Steuervorrichtung (44), die von dem Haushaltsgerät (10) elektrisch isoliert ist, steuerbar ist,
**dadurch gekennzeichnet, dass**
- ein Steuereingang des Schalters (20) mit einer Empfangsspule (26) verbunden ist, die auf ein durch die Steuervorrichtung (44) erzeugtes Magnetfeld anspricht,
- das Haushaltsgerät (10) ein Induktionskochfeld mit einer Induktionsspule ist, wobei die Empfangsspule (26) die Induktionsspule ist, und
- ein Gleichrichter vorzugsweise zwischen die Empfangsspule (26) und den Steuereingang des Schalters (20) geschaltet ist.

2. Haushaltsgerät nach Anspruch 1,
**dadurch gekennzeichnet, dass**
der Hochspannungseingang (36) des Schalters (20) mit einer Netzleitung (22) verbunden werden kann oder verbunden ist.

3. Haushaltsgerät nach Anspruch 1 oder 2,
**dadurch gekennzeichnet, dass**
der Hochspannungsausgang (38) des Schalters (20) mit wenigstens einer Leistungselektronik (16) und/oder mit einer Leistungsversorgung (18) verbunden ist.

4. Haushaltsgerät nach einem der vorhergehenden Ansprüche,
**dadurch gekennzeichnet, dass**
die Steuervorrichtung (44) ein integrierter Bestandteil des Haushaltsgeräts (10) ist und/oder ein externes Teil ist, das dem Haushaltsgerät (10) entspricht.

5. Haushaltsgerät nach Anspruch 3,
**dadurch gekennzeichnet, dass**
die Leistungselektronik (16) dafür ausgelegt ist, wenigstens einem Hochspannungsgerät (26) Leistung zuzuführen.

6. Haushaltsgerät nach Anspruch 3,
**dadurch gekennzeichnet, dass**
die Leistungsversorgung (18) dafür ausgelegt ist, bei eine niedrige Spannung zu erzeugen, wobei vorzugsweise die niedrige Spannung für wenigstens eine Steuereinheit (14) bereitgestellt wird.

7. Haushaltsgerät nach einem der vorhergehenden Ansprüche,
**dadurch gekennzeichnet, dass**
der Schalter ein Relais (20) ist.

8. Haushaltsgerät nach einem der vorhergehenden Ansprüche,
**dadurch gekennzeichnet, dass**
die Steuervorrichtung (44) eine kompakte getrennte Vorrichtung (28, 30) ist, wobei die getrennte Vorrichtung (28, 30) ein integrierter Bestandteil des Haushaltsgeräts (10) oder eine externe Vorrichtung ist.

9. Haushaltsgerät nach einem der vorhergehenden Ansprüche,
**dadurch gekennzeichnet, dass**
die Steuervorrichtung (44) wenigstens eine weitere Spule (28) enthält.

10. Haushaltsgerät nach Anspruch 9,
**dadurch gekennzeichnet, dass**
die Steuervorrichtung (44) wenigstens eine Sendevorrichtung (30) enthält, wobei die Sendevorrichtung (30) vorzugsweise dazu vorgesehen ist, die weitere Spule (28) anzusteuern.

11. Haushaltsgerät nach einem der vorhergehenden Ansprüche,
**dadurch gekennzeichnet, dass**
die Steuervorrichtung (44) wenigstens eine aktive NFC- oder RFID-Schaltung enthält.

12. Haushaltsgerät nach einem der vorhergehenden Ansprüche,
**dadurch gekennzeichnet, dass**
die Steuervorrichtung (28, 30) wenigstens einen Kondensator enthält, wobei der Kondensator während eines Normalbetriebs des Haushaltsgeräts (10) geladen werden kann.

13. Haushaltsgerät nach Anspruch 12,
**dadurch gekennzeichnet, dass**
die in dem Kondensator gespeicherte Energie geeignet ist für die Versorgung einer Hilfsleistungsversorgung (24), wobei die Hilfsleistungsversorgung (24) dazu vorgesehen ist, den Schalter (20) zu schließen, um das Haushaltsgerät (10) zu starten.

## Revendications

1. Appareil ménager (10) conçu pour être commuté vers un mode de veille :
- l'appareil ménager (10) comportant au moins un commutateur (20) pouvant être commuté entre un état ouvert et un état fermé, le commutateur (20) étant à l'état ouvert dans le mode de veille,
- le commutateur (20) comprend au moins une entrée à haute tension et au moins une sortie à haute tension,
- l'entrée à haute tension et la sortie à haute tension étant conçues pour supporter la tension du secteur,
- l'entrée à haute tension et la sortie à haute tension étant galvaniquement déconnectées l'une de l'autre à l'état ouvert du commutateur (20),
- l'entrée à haute tension et la sortie à haute tension étant galvaniquement reliées l'une à l'autre à l'état fermé du commutateur (20), et
- le commutateur (20) pouvant être commandé par au moins un dispositif (44) de commande isolé électriquement de l'appareil ménager (10),
**caractérisé en ce que**
- une entrée de commande du commutateur (20) est reliée à une bobine réceptrice (26) qui réagit à un champ magnétique généré par le dispositif (44) de commande,
- l'appareil ménager (10) est une table de cuisson à induction comportant une bobine d'induction, la bobine réceptrice (26) étant la bobine d'induction, et
- un redresseur est de préférence interconnecté entre la bobine réceptrice (26) et l'entrée de commande du commutateur (20).

2. Appareil ménager selon la revendication 1, **caractérisé en ce que**
l'entrée (36) à haute tension du commutateur (20) est ou peut être reliée à une ligne (22) de secteur.

3. Appareil ménager selon la revendication 1 ou 2, **caractérisé en ce que**
la sortie (38) à haute tension du commutateur (20) est reliée à au moins une électronique (16) de puissance et/ou à une alimentation électrique (18).

4. Appareil ménager selon l'une quelconque des revendications précédentes,
**caractérisé en ce que**
le dispositif (44) de commande est une partie intégrée de l'appareil ménager (10) et/ou une partie externe correspondant avec l'appareil ménager (10).

5. Appareil ménager selon la revendication 3, **caractérisé en ce que**
l'électronique (16) de puissance est conçue pour fournir une alimentation à au moins un appareil (26) à haute tension.

6. Appareil ménager selon la revendication 3, **caractérisé en ce que**
l'alimentation électrique (18) est conçue pour générer à une basse tension, ladite basse tension étant de préférence fournie à au moins une unité (14) de commande.

7. Appareil ménager selon l'une quelconque des revendications précédentes,
**caractérisé en ce que**
le commutateur est un relais (20).

8. Appareil ménager selon l'une quelconque des revendications précédentes,
**caractérisé en ce que**
le dispositif (44) de commande est un dispositif distinct (28, 30) compact, ledit dispositif distinct (28, 30) étant une partie intégrée de l'appareil ménager (10) ou un dispositif externe.

9. Appareil ménager selon l'une quelconque des revendications précédentes,
**caractérisé en ce que**
le dispositif (44) de commande comporte au moins une bobine supplémentaire (28).

10. Appareil ménager selon la revendication 9, **caractérisé en ce que**
le dispositif (44) de commande comporte au moins un dispositif émetteur (30), ledit dispositif émetteur (30) étant de préférence prévu pour exciter la bobine supplémentaire (28).

11. Appareil ménager selon l'une quelconque des revendications précédentes,
**caractérisé en ce que**
le dispositif (44) de commande comprend au moins un circuit NFC ou RFID actif.

12. Appareil ménager selon l'une quelconque des revendications précédentes,
**caractérisé en ce que**
le dispositif (28, 30) de commande comprend au moins un condensateur, ledit condensateur pouvant être chargé pendant un fonctionnement standard de l'appareil ménager (10).

13. Appareil ménager selon la revendication 12, **caractérisé en ce que**
l'énergie stockée dans ledit condensateur est conçue pour fournir une alimentation électrique auxiliaire (24), ladite alimentation électrique auxiliaire (24) servant à fermer le commutateur (20) afin de démarrer l'appareil ménager (10).
